# EUROPEAN PATENT SPECIFICATION

(11) **EP 4 311 379 B1**
(45) Date of publication and mention of the grant of the patent: **30.04.2025**
(21) Application number: 22794244.8
(22) Date of filing: 29.01.2022
(51) Int. Cl.: H05K 1/18, H01Q 1/22, H01Q 3/26, H01Q 21/00

(54) **MULTI-BEAM CHIP INTEGRATION MODULE AND PHASED ARRAY SYSTEM**
MEHRSTRAHLCHIPINTEGRATIONSMODUL UND PHASENGESTEUERTES ARRAYSYSTEM
MODULE D'INTÉGRATION DE PUCE MULTIFAISCEAU ET SYSTÈME DE RÉSEAU À COMMANDE DE PHASE

(30) Priority: 29.04.2021 CN 202110474739
(43) Date of publication of application: 24.01.2024
(73) Proprietor: Chengdu T-Ray Technology Co., Ltd., Chengdu, Sichuan 610015 (CN); Southeast University, Nanjing, Jiangsu 211189 (CN)
(72) Inventor: LIU, Huiqi, Chengdu, Sichuan 610015 (CN); ZHAO, Dixian, Chengdu, Sichuan 610015 (CN); YOU, Xiaohu, Chengdu, Sichuan 610015 (CN); CHEN, Zhihui, Chengdu, Sichuan 610015 (CN)
(74) Representative: Caspary, Karsten
(86) International application number: PCT/CN2022/074997
(87) International publication number: WO 2022/227763

(56) References cited:
- CN-A- 106 207 492
- CN-A- 110 138 408
- CN-A- 111 541 470
- CN-A- 112 003 003
- CN-A- 112 003 003
- CN-A- 113 141 708
- CN-U- 209 198 649
- US-B1- 10 757 812

## Description

### FIELD OF THE DISCLOSURE

The present disclosure relates to the field of phased array antennas, and more particularly to a multi-beam chip integration module and a phased array system.

### BACKGROUND OF THE DISCLOSURE

With the development of satellite communications and radar technology, high-rate and large-capacity data transmission capabilities are currently provided mainly through Ku and Ka frequency bands, and at the same time, there is an increasing demand for miniaturization, economy, channel capacity, anti-interference, coverage performance and multi-targeting. In particular, the edge problem and the near-far effect caused by a large coverage angle are difficult to solve by using a common linear array or planar array single-beam antenna, so that multi-beam technology needs to be adopted. The user capacity of the communication system can be greatly improved through inter-beam frequency multiplexing, and meanwhile, multi-beam phased array antennas have obvious advantages in remote control, telemetering, tracking and positioning and information transmission of multiple targets. The application of a Ka frequency band and a higher one may provide advantages of high-rate and high-capacity data transmission, but meanwhile, due to the continuous reduction of antenna array units, the size of the array continues to decrease, ushering in greater challenges in integration and miniaturization. Especially in multi-beam high-frequency band phased array antennas, the difficulties become even greater.

CN 106 207 492 A and CN 112 003 003 A disclose a multi-beam chip integration module, comprising a first printing board with at least one set of first-type chips surface mounted to its first side and at least one set of second-type chips surface mounted to its second side, wherein there is one layer of second-type chips.

### SUMMARY OF THE DISCLOSURE

It is an object of the present disclosure to provide a multi-beam chip integration module and a phased array system to at least partially ameliorate the aforementioned problems.

In order to achieve the object above, the technical solutions employed in the embodiments of the present disclosure provide a multi-beam chip integration module according to the appended claims.

In one possible implementation, power supply pins of each set of multi-beam channel chips are respectively connected to corresponding power supply channels in the first side of the first printed board, and control pins of each set of multi-beam channel chips are respectively connected to corresponding control channels in the first side of the first printed board.

In one possible implementation, a power supply pin of the multi-beam synthesis network chip is connected to a corresponding power supply channel in the second side of the first printed board, and a control pin of the multi-beam synthesis network chip is connected to a corresponding control channel in the second side of the first printed board.

In a second aspect, embodiments of the present disclosure provide a phased array system, the phased array system comprising an antenna unit, a second printed board, and at least one set of multi-beam chip integration modules;

The multi-beam chip integration module comprises a first printing board, at least one set of first-type chips, and at least one set of second-type chips; the at least one set of first-type chips is surface mounted to a first side of the first printing board; the at least one set of second-type chips is surface mounted to a second side of the first printing board; the second side of the first printing board is an opposite side parallel to the first side of the first printing board;

A second side of the multi-beam chip integration module is surface mounted to one side of the second printed board, and the first printed board and the second printed board together define a hollow cavity in which the at least one set of second-type chips is disposed;

The antenna unit is surface mounted to the other side of the second printed board.

In one possible implementation, the first-type chips are multi-beam channel chips, while the second-type chips are multi-beam synthesis network chips; the number of the multi-beam synthesis network chips is 1, and the number of the multi-beam channel chips is 4;

Each set of multi-beam channel chips are respectively connected to different pins in the multi-beam synthesis network chip through different beam channels in the first printed board;

Signal pins in each set of multi-beam channel chips are respectively connected to different radio frequency signal channels in the first printed board, so as to be connected to corresponding antenna units.

In one possible implementation, the second printed board is provided with an antenna feed network, radio frequency signal channels in the first printed board are respectively connected to access points of the antenna feed network, and output points of the antenna feed network are respectively connected to different antenna units.

In one possible implementation, radio frequency signal channels in the first printed board are respectively connected to access points of the antenna feed network via solder joints, the solder joints having a cross-sectional diameter greater than a thickness of the multi-beam synthesis network chip.

In one possible implementation, the phased array system further comprises a heat dissipation module, one side of the heat dissipation module abutting against the first-type chips.

Relative to the prior art, embodiments of the present disclosure provide a multi-beam chip integration module and a phased array system, wherein the multi-beam chip integration module comprises a first printing board, at least one set of first-type chips, and at least one set of second-type chips, the at least one set of first-type chips surface mounted to a first side of the first printing board, and the at least one set of second-type chips surface mounted to a second side of the first printing board, and wherein the second side of the first printing board is an opposite side parallel to the first side of the first printing board. Where the number and size (specification) of the first-type chips and the second-type chips do not change, surface mounting the first-type chips and the second-type chips to two sides of the first printing board requires a smaller area, i.e., a smaller size, of the first printing board as compared to surface mounting the same to one side of the first printing board. Therefore, the chip layout following the reduced size of the printed board can be satisfied, the wiring complexity of the antenna network can be reduced, and the chip layout can be completed in a simple and rapid manner.

In order to make the above objects, features and advantages of the present disclosure more apparent, preferred embodiments are exemplified below, and are described in detail as follows in conjunction with the accompanying drawings.

### BRIEF DESCRIPTION OF THE DRAWINGS

In order to more clearly illustrate the technical solutions of the embodiments of the present disclosure, the accompanying drawings to be used in the embodiments will be briefly introduced below. It should be understood that the following figures are only illustrative of certain embodiments of the present disclosure, and therefore should not be regarded as limiting to its scope. For those skilled in the art, other related drawings could also be obtained from these drawings without exercise of any ingenuity.
FIG. 1 is a cross-sectional view of a multi-beam chip integration module according to an embodiment of the present disclosure;
FIG. 2 is a top view of a multi-beam chip integration module according to an embodiment of the present disclosure;
FIG. 3 is a bottom view of a multi-beam chip integration module according to an embodiment of the present disclosure;
FIG. 4 shows schematically a structure of a phased array system according to an embodiment of the present disclosure;
FIG. 5 shows schematically the distribution of a multi-beam chip integration module in the second printed board according to an embodiment of the present disclosure; and
FIG. 6 shows schematically the distribution of an antenna unit in the second printed board according to an embodiment of the present disclosure.

Reference numbers in the figures include: 10-multi-beam chip integration module; 101-first-type chip; 102-second-type chip; 103-first printed board; 20-second printed board; 30-antenna unit; 40-heat dissipation module; 50-solder joint; 60-antenna feed network.

### DETAILED IMPLEMENTATION OF THE DISCLOSURE

In order to make the objects, technical solutions and advantages of the embodiments of the present disclosure clearer, the technical solutions in the embodiments of the present disclosure will be clearly and completely described below in conjunction with the accompanying drawings. Apparently, the embodiments described herein are some, but not all, embodiments of the present disclosure. The components in the embodiments of the present disclosure described and illustrated herein may generally be arranged and designed in a variety of different configurations.

Accordingly, the following detailed description of the embodiments of the present disclosure as provided in the accompanying drawings is not intended to limit the scope of the present invention which is defined by the appended claims.

It should be noted that like reference numerals and letters refer to like items in the following figures, and thus, once an item is defined in one figure, it need not be further defined and explained in subsequent ones. Moreover, the terms "first", "second" and the like, if any, are used solely to distinguish one from another and are not to be construed as indicating or implying relative importance.

It is to be noted that relational terms such as first and second herein are used only to distinguish one entity or operation from another, and do not necessarily require or imply any such actual relationship or order between those entities or operations. Furthermore, the terms "including", "comprising", or any other variant thereof, are intended to cover non-exclusive inclusion, such that a process, method, article, or apparatus comprising a set of elements includes not only those elements, but also other elements not expressly listed, or elements that are inherent to such process, method, article or apparatus. Without further limitation, the fact that an element is defined by the phrase "comprising a ......" does not preclude the existence of additional identical elements in the process, method, article or apparatus that comprises the element.

In the description of the present disclosure, it should be noted that an orientation or a positional relationship indicated by such terms as "upper", "lower", "inner" and "outer", if any, is based on that shown in the drawings, or that of the product of the present disclosure as it is in use. This is only for ease and simplicity of description, without indicating or implying that the device or the element referred to must have a specific orientation, or be constructed and operated in a particular orientation, and thus it should not be construed as limiting to the present disclosure.

In the description of the present disclosure, it should also be noted that, unless otherwise expressly specified or defined, the terms "provided" and "connected" and the like are to be understood in a broad sense. For example, it may be a fixed connection, a detachable connection, or an integral connection; it may be a mechanical connection or an electrical connection; it may be a direct connection, or an indirect connection through an intermediary, or an internal communication of two elements. For a person of ordinary skill in the art, the specific meanings of these terms in the present disclosure may be understood in specific contexts.

Some embodiments of the present disclosure are described in detail below in conjunction with the accompanying drawings. The following embodiments and features therein may be combined with each other in the absence of conflicts.

Currently, the existing multi-beam phased array antennas may be divided into analog multi-beam phased array antennas and digital multi-beam phased array antennas according to the beam formation. Analog multi-beam phased array antennas can implement multiple beams without reducing the signal-to-noise ratio received by the antennas, and the solution is simple and feasible, but requires too much hardware. Digital multi-beam phased array antennas are to digitize intermediate frequency signals and implement software, which has higher requirements for algorithms and hardware.

The commonly used dual-beam phased array antennas are generally analog dual-beam phased array antennas. There are not many research results for phased array antennas with more beams. Under the premise of ever increasing requirements for miniaturization and integration, it is very difficult to specifically implement the layout of a multi-beam high-frequency phased array.

When a traditional multi-beam phased array system is used in millimeter wave or higher frequency bands, due to the reduced size of antenna array units and the reduced spacing therebetween, the panel size of the printed board is reduced in case of a same number of array units, while the size of multi-beam multi-channel chips is relatively large, which leads to serious restrictions on the layout. Consequently, the wiring for the multi-layer feed synthesis antenna network is very complicated and difficult, or even impossible to implement.

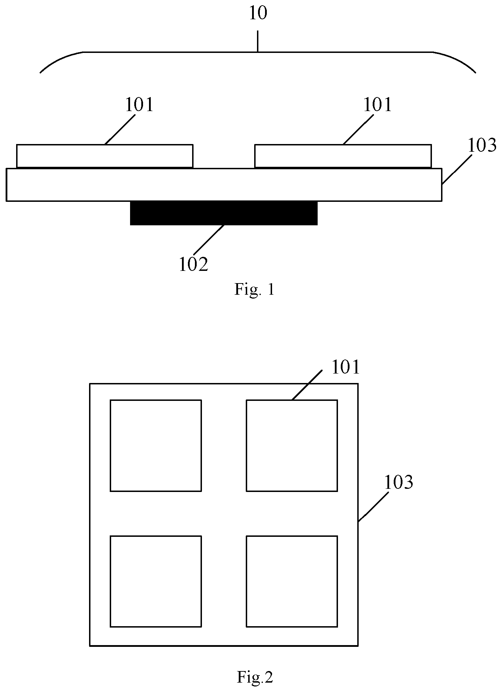

To overcome the above problems, embodiments of the present disclosure provide a multi-beam chip integration module. Reference is made to FIG. 1, which is a cross-sectional view of a multi-beam chip integration module 10 according to an embodiment of the present disclosure. As shown in FIG. 1, the multi-beam chip integration module 10 includes a first printed board 103, at least one set of first-type chips 101, and at least one set of second-type chips 102.

The at least one set of the first-type chips 101 is surface mounted to a first side of the first printed board 103.

Optionally, reference is made to FIG. 2, which is a top view of a multi-beam chip integration module 10 according to an embodiment of the present disclosure. As shown in FIG. 2, the first-type chips 101 a resurface mounted to a first side of the first printed board 103. The number of the first-type chips 101 is shown as 4 in FIG. 2, which is for ease of presentation and reference, and there is no limitation on the number of the first-type chips 101.

The at least one set of second-type chips 102 is surface mounted to a second side of the first printed board 103.

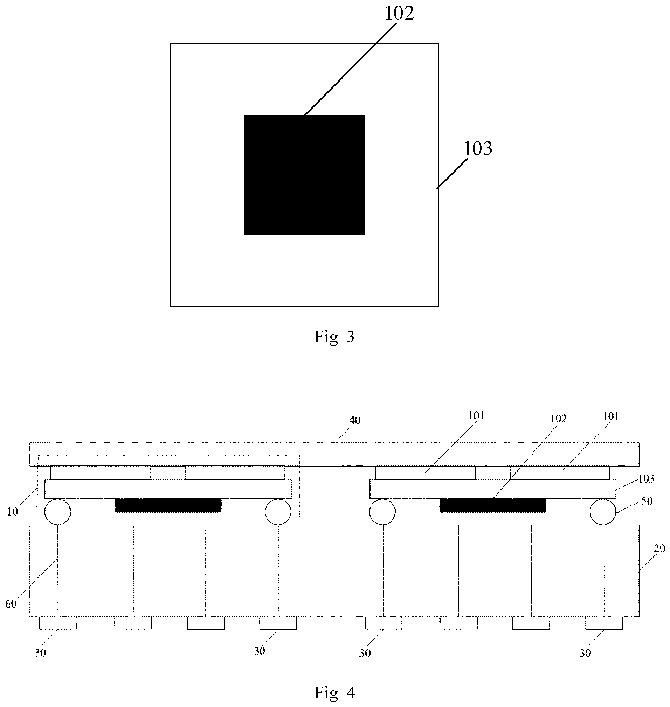

Optionally, reference is made to FIG. 3, which shows a bottom view of a multi-beam chip integration module 10 according to an embodiment of the present disclosure. As shown in FIG. 3, the second-type chips 102 a resurface mounted to the second side of the first printed board 103. The number of the second-type chips 102 is shown as 1 in FIG. 3, which is for ease of presentation and reference, and there is no limitation on the number of the second-type chips 102.

Where the number and size (specification) of the first-type chips 101 and the second-type chips 102 do not change, surface mounting the first-type chips 101 and the second-type chips 102 to two sides of the first printing board 103requires a smaller area, i.e., a smaller size, of the first printing board 103 as compared to surface mounting the same to one side of the first printing board 103. Therefore, the chip layout following the reduced size of the printed board can be satisfied, the wiring complexity of the antenna network can be reduced, and the chip layout can be completed in a simple and rapid manner.

In the embodiment of the present disclosure, the second side of the first printed board 103 is an opposite side that is parallel to the first side of the first printed board 103.

In summary, embodiments of the present disclosure provide a multi-beam chip integration module, wherein the multi-beam chip integration module comprises a first printing board, at least one set of first-type chips, and at least one set of second-type chips, wherein the at least one set of first-type chips is surface mounted to a first side of the first printing board, wherein the at least one set of second-type chips is surface mounted to a second side of the first printing board, and wherein the second side of the first printing board is an opposite side parallel to the first side of the first printing board. Where the number and size (specification) of the first-type chips and the second-type chips do not change, surface mounting the first-type chips and the second-type chips to two sides of the first printing board requires a smaller area, i.e., a smaller size, of the first printing board as compared to surface mounting the same to one side of the first printing board. Therefore, the chip layout following the reduced size of the printed board can be satisfied, the wiring complexity of the antenna network can be reduced, and the chip layout can be completed in a simple and rapid manner.

According to the invention, the first-type chips 101 are multi-beam channel chips, while the second-type chips 102 are multi-beam synthesis network chips; the number of the multi-beam synthesis network chips is 1, and the number of the multi-beam channel chips is 4.

Each set of multi-beam channel chips are respectively connected to different pins in the multi-beam synthesis network chip through different beam channels in the first printed board 103.

The multi-beam channel chips and the multi-beam synthesis network chip are interconnected via a multilayer network constructed by beam channels of the first printed board 103. The multi-beam synthesis network chip is used to perform network synthesis or decomposition of input and output signals of the multi-beam channel chips.

According to the invention, there are two layers of multi-beam synthesis network chips, wherein the multi-beam synthesis network chips of the lower layer are respectively connected to corresponding multi-beam channel chips, and the multi-beam synthesis network chips of the upper layer are respectively connected to an external control device and multi-beam synthesis network chips of the lower layer. Optionally, multi-beam synthesis network chips of the upper layer are connected to an external control device and multi-beam synthesis network chips of the lower layer via corresponding pins in the first printed board 103.

Signal pins in each set of multi-beam channel chips are respectively connected to different radio frequency signal channels in the first printed board 103, so as to be connected to corresponding antenna units.

Optionally, multi-beam channel chips may accomplish transceiving of radio frequency signals corresponding to antenna units through radio frequency signal channels.

In one possible implementation, power supply pins of each set of multi-beam channel chips are respectively connected to corresponding power supply channels in the first side of the first printed board 103, and control pins of each set of multi-beam channel chips are respectively connected to corresponding control channels in the first side of the first printed board 103.

In one possible implementation, a power supply pin of the multi-beam synthesis network chip is connected to a corresponding power supply channel in the second side of the first printed board 103, and a control pin of the multi-beam synthesis network chip is connected to a corresponding control channel in the second side of the first printed board 103.

Optionally, the first printed board 103 in the embodiment of the present disclosure is a printed circuit board fabricated via a Low Temperature Co-fired Ceramic (LTCC) process.

Low-temperature co-fired ceramic process refers to a process of preparing low-temperature sintered ceramic powder into a green tape with a precise thickness and density as a circuit substrate material, subjecting the green tape to laser drilling, microporous grouting, and precision conductor paste printing and the like to form a desired circuit pattern, embedding a plurality of passive components therein, then laminating together, and sintering at 900°C to manufacture a passive integrated component of a three-dimensional circuit network, or to manufacture a three-dimensional circuit substrate with a built-in passive element, with an IC and an active device mounted on its surface to make a passive/active integrated functional module.

Embodiments of the present disclosure further provide a phased array system comprising an antenna unit 30, a second printed board 20, and at least one set of multi-beam chip integration modules 10, as shown in FIG. 4.

A multi-beam chip integration module 10 includes a first printing board 103, at least one set of first-type chips 101, and at least one set of second-type chips 102; the at least one set of first-type chips 101 is surface mounted to a first side of the first printing board 103; the at least one set of second-type chips 102 is surface mounted to a second side of the first printing board 103; the second side of the first printing board 103 is an opposite side parallel to the first side of the first printing board 103.

A second side of the multi-beam chip integration module 10 is surface mounted to one side of the second printed board 20, and the first printed board 103 and the second printed board 20 together define a hollow cavity, in which cavity the at least one set of the second-type chips 102 is disposed;

The antenna unit 30 is surface mounted to the other side of the second printed board 20.

Optionally, when the number of antenna units 30 is certain, the panel size of the printed board is reduced with the same number of antenna units 30 due to the reduced size of the antenna units 30 and the reduced spacing between the antenna units 30. In the phased array system provided in the embodiments of the present disclosure, where the number and size (specification) of the first-type chips 101 and the second-type chips 102 do not change, surface mounting the first-type chips 101 and the second-type chips 102 to two sides of the first printing board 103 requires a smaller area, i.e., a smaller size, of the first printing board 103 as compared to surface mounting the same to one side of the first printing board 103. Therefore, the chip layout following the reduced size of the printed board can be satisfied, the wiring complexity of the antenna network can be reduced, and the chip layout can be completed in a simple and rapid manner.

In one possible implementation, the first-type chips 101 are multi-beam channel chips, while the second-type chips 102 are multi-beam synthesis network chips; the number of the multi-beam synthesis network chips is 1, and the number of the multi-beam channel chips is 4.

Each set of multi-beam channel chips are respectively connected to different pins in the multi-beam synthesis network chip through different beam channels in the first printed board 103.

Signal pins in each set of multi-beam channel chips are respectively connected to different radio frequency signal channels in the first printed board 103, so as to be connected to corresponding antenna units.

In one possible implementation, power supply pins of each set of multi-beam channel chips are respectively connected to corresponding power supply channels in the first side of the first printed board 103, and control pins of each set of multi-beam channel chips are respectively connected to corresponding control channels in the first side of the first printed board 103.

In one possible implementation, a power supply pin of the multi-beam synthesis network chip is connected to a corresponding power supply channel in the second side of the first printed board 103, and a control pin of the multi-beam synthesis network chip is connected to a corresponding control channel in the second side of the first printed board 103.

Still referring to FIG. 4, in one possible implementation, the second printed board 20 is provided with an antenna feed network 60, radio frequency signal channels in the first printed board 103 are respectively connected to access points of the antenna feed network 60, and output points of the antenna feed network 60 are respectively connected to different antenna units 30.

Still referring to FIG. 4, in one possible implementation, the radio frequency signal channels in the first printed board 103 are respectively connected to the access points of the antenna feed network 60 via solder joints 50, the solder joints 50 having a cross-sectional diameter greater than a thickness of the multi-beam synthesis network chip.

With continued reference to FIG. 4, in one possible implementation, the phased array system further includes a heat dissipation module 40, one side of the heat dissipation module 40 abutting against the first-type chips 101.

The heat dissipation module 40 may be an aluminum alloy heat conductor for exchanging heat generated by the multi-beam chip integration module 10 with the outside, thereby playing a role of heat dissipation.

Optionally, the second printed board 20 in the embodiment of the present disclosure is a PCB prepared via a low temperature co-fired ceramic process.

In the phased array system provided by the embodiments of the present disclosure, multiple chips are first integrated into a multi-beam chip integration module 10, the multi-beam chip integration module 10 is surface mounted to a second printed board 20, and antennas, feed, control and the like are integrated through the second printed board 20, thereby solving the problem that a multi-beam high-frequency phased array antenna cannot be laid out by means of a highly integrated technical solution. In this way, the problem that a traditional phased array antenna is difficult or even impossible to be laid out in case of multiple beams and high frequencies can be solved. Using an LTCC multi-layer network printed board to re-integrate chips, the integration level is higher, and a module capable of being independently mounted is formed, such that the problem caused by the reduction of the array size is solved through the use of multiple modules. The following technical effects have been achieved: by integrating multiple chips off-chip through an LTCC multi-layer network, the layout space required by the chips is compressed, thus solving the problem of layout failure due to the reduced size of the antenna array; the flexibility of use is increased, and multi-beam chip integration modules 10 can be made into multiple standards according to actual usage conditions, integrating different numbers of chips, such that the module is flexible in use, high in standardization and high in integration, and able to be applied to a variety of multi-beam arrays.

It should be noted that in the prior art, most of multi beams are dual beams, and there is a lack of corresponding solutions for 4beams and 8beams, while the multi-beam chip integration module provided in the embodiments of the present disclosure can be used to realize 8-beam integration.

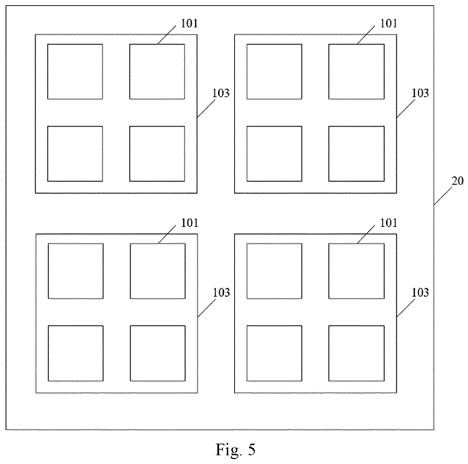

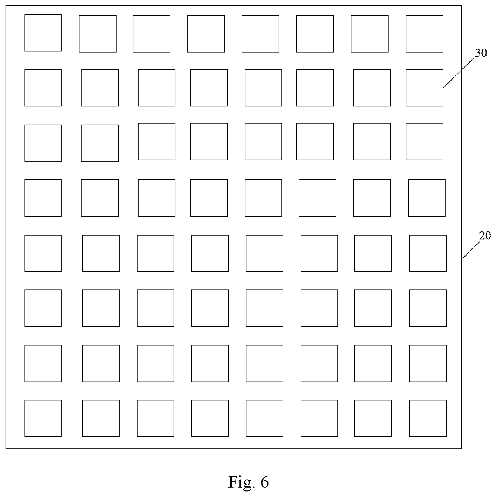

Embodiments of the present disclosure also provide the respective distribution of the multi-beam chip integration modules 10 and the antenna units 30 in relation to the second printed board 20 in the phased array system, with reference to FIGS. 5 and 6. FIG. 5 shows schematically the distribution of the multi-beam chip integration modules 10 in the second printed board 20, while FIG. 6 shows schematically the distribution of the antenna units 30 in the second printed board 20.

The foregoing are only preferred embodiments of the present disclosure, which are not intended to limit the present invention, which is defined by the appended claims.

It is apparent to those skilled in the art that the present disclosure is not limited to the details of the exemplary embodiments described above, and that the present disclosure may be otherwise enabled in other specific forms without departing from the invention as defined by the appended claims.

Accordingly, the embodiments are to be regarded as exemplary and non-limiting in each and every point of view, and the scope of the present disclosure is defined by the appended claims and not by the foregoing description, and is therefore intended to encompass all changes falling within the appended claims. Any reference sign in a claim should not be construed as limiting the claim concerned.

## Claims

1. A multi-beam chip integration module (10), comprising a first printing board (103), at least one set of first-type chips (101), and at least one set of second-type chips (102),
wherein the at least one set of first-type chips (101) is surface mounted to a first side of the first printing board (103),
wherein the at least one set of second-type chips (102) is surface mounted to a second side of the first printing board (103), and
wherein the second side of the first printing board (103) is an opposite side parallel to the first side of the first printing board (103);
wherein the first-type chips (101) are multi-beam channel chips, while the second-type chips (102) are multi-beam synthesis network chips; the number of the multi-beam synthesis network chips being 1, and the number of the multi-beam channel chips being 4;
wherein each set of multi-beam channel chips are respectively connected to different pins in the multi-beam synthesis network chip through a multilayer network constructed by different beam channels in the first printed board (103);
wherein signal pins in each set of multi-beam channel chips are respectively connected to different radio frequency signal channels in the first printed board, so as to be connected to corresponding antenna units;
wherein the multi-beam synthesis network chip is configured to perform network synthesis or decomposition of input and output signals of the multi-beam channel chips;
wherein there are two layers of multi-beam synthesis network chips, wherein the multi-beam synthesis network chips of the lower layer are respectively connected to corresponding multi-beam channel chips, and the multi-beam synthesis network chips of the upper layer are respectively connected to an external control device and multi-beam synthesis network chips of the lower layer.

2. The multi beam chip integration module (10) according to claim 1, wherein power supply pins of each set of multi-beam channel chips are respectively connected to corresponding power supply channels in the first side of the first printed board (103), and control pins of each set of multi-beam channel chips are respectively connected to corresponding control channels in the first side of the first printed board (103).

3. The multi beam chip integration module (10) according to claim 1, wherein a power supply pin of the multi-beam synthesis network chip is connected to a corresponding power supply channel in the second side of the first printed board (103), and a control pin of the multi-beam synthesis network chip is connected to a corresponding control channel in the second side of the first printed board (103).

4. A phased array system, wherein the phased array system comprises an antenna unit (30), a second printed board (20), and at least one set of multi-beam chip integration modules (10) according to one of claims 1 to 3.

5. The phased array system according to claim 4, wherein the second printed board (20) is provided with an antenna feed network, radio frequency signal channels in the first printed board (103) are respectively connected to access points of the antenna feed network, and output points of the antenna feed network are respectively connected to different antenna units (30).

6. The phased array system according to claim 5, wherein radio frequency signal channels in the first printed board (103) are respectively connected to access points of the antenna feed network via solder joints (50), the solder joints (50) having a cross-sectional diameter greater than a thickness of the multi-beam synthesis network chip.

7. The phased array system according to claim 4, wherein the phased array system further comprises a heat dissipation module (40), one side of the heat dissipation module (40) abutting against the first-type chips (101).

## Patentansprüche

1. Mehrstrahl-Chip-Integrationsmodul (10), das eine erste Leiterplatte (103), mindestens eine Gruppe von Chips eines ersten Typs (101) und mindestens eine Gruppe von Chips eines zweiten Typs (102) aufweist,
wobei die mindestens eine Gruppe von Chips des ersten Typs (101) oberflächenmontiert auf einer ersten Seite der ersten Leiterplatte (103) ist,
wobei die mindestens eine Gruppe von Chips des zweiten Typs (102) oberflächenmontiert auf einer zweiten Seite der ersten Leiterplatte (103) ist, und
wobei die zweite Seite der ersten Leiterplatte (103) eine gegenüberliegende und parallel zur ersten Seite verlaufende Seite der ersten Leiterplatte (103) ist;
wobei die Chips des ersten Typs (101) Mehrstrahl-Kanalchips sind, während die Chips des zweiten Typs (102) Mehrstrahl-Synthesenetzwerk-Chips sind; die Anzahl der Mehrstrahl-Synthesenetzwerk-Chips 1 beträgt und die Anzahl der Mehrstrahl-Kanalchips 4 beträgt;
wobei jede Gruppe von Mehrstrahl-Kanalchips jeweils über ein durch verschiedene Strahlkanäle in der ersten Leiterplatte (103) gebildetes Mehrschichtnetzwerk mit unterschiedlichen Pins im Mehrstrahl-Synthesenetzwerk-Chip verbunden ist;
wobei Signalpins jeder Gruppe von Mehrstrahl-Kanalchips jeweils mit unterschiedlichen Hochfrequenzsignal-Kanälen in der ersten Leiterplatte verbunden sind, um mit entsprechenden Antenneneinheiten verbunden zu werden;
wobei der Mehrstrahl-Synthesenetzwerk-Chip dazu eingerichtet ist, eine Netzwerksynthese oder Zerlegung von Ein- und Ausgangssignalen der Mehrstrahl-Kanalchips durchzuführen;
wobei es zwei Schichten von Mehrstrahl-Synthesenetzwerk-Chips gibt, wobei die Mehrstrahl-Synthesenetzwerk-Chips der unteren Schicht jeweils mit entsprechenden Mehrstrahl-Kanalchips verbunden sind und die Mehrstrahl-Synthesenetzwerk-Chips der oberen Schicht jeweils mit einer externen Steuervorrichtung und den Mehrstrahl-Synthesenetzwerk-Chips der unteren Schicht verbunden sind.

2. Mehrstrahl-Chip-Integrationsmodul (10) nach Anspruch 1, wobei Versorgungspins jeder Gruppe von Mehrstrahl-Kanalchips jeweils mit entsprechenden Versorgungsleitungen in der ersten Seite der ersten Leiterplatte (103) verbunden sind und Steuerpins jeder Gruppe von Mehrstrahl-Kanalchips jeweils mit entsprechenden Steuerleitungen in der ersten Seite der ersten Leiterplatte (103) verbunden sind.

3. Mehrstrahl-Chip-Integrationsmodul (10) nach Anspruch 1, wobei ein Versorgungspin des Mehrstrahl-Synthesenetzwerk-Chips mit einer entsprechenden Versorgungsleitung in der zweiten Seite der ersten Leiterplatte (103) verbunden ist und ein Steuerpin des Mehrstrahl-Synthesenetzwerk-Chips mit einer entsprechenden Steuerleitung in der zweiten Seite der ersten Leiterplatte (103) verbunden ist.

4. Phased-Array-System, wobei das Phased-Array-System eine Antenneneinheit (30), eine zweite Leiterplatte (20) und mindestens eine Gruppe von Mehrstrahl-Chip-Integrationsmodulen (10) nach einem der Ansprüche 1 bis 3 aufweist.

5. Phased-Array-System nach Anspruch 4, wobei die zweite Leiterplatte (20) mit einem Antennen-Speisenetzwerk versehen ist, Hochfrequenzsignal-Kanäle in der ersten Leiterplatte (103) jeweils mit Zugangspunkten des Antennen-Speisenetzwerks verbunden sind und Ausgangspunkte des Antennen-Speisenetzwerks jeweils mit unterschiedlichen Antenneneinheiten (30) verbunden sind.

6. Phased-Array-System nach Anspruch 5, wobei Hochfrequenzsignal-Kanäle in der ersten Leiterplatte (103) jeweils über Lötverbindungen (50) mit Zugangspunkten des Antennen-Speisenetzwerks verbunden sind, wobei die Lötverbindungen (50) einen Querschnittsdurchmesser aufweisen, der größer ist als die Dicke des Mehrstrahl-Synthesenetzwerk-Chips.

7. Phased-Array-System nach Anspruch 4, wobei das Phased-Array-System des Weiteren ein Wärmeableitungsmodul (40) aufweist, wobei eine Seite des Wärmeableitungsmoduls (40) an die Chips des ersten Typs (101) angrenzt.

## Revendications

1. Module d'intégration de puces multifaisceau (10), comprenant un premier circuit imprimé (103), au moins un ensemble de puces d'un premier type (101) et au moins un ensemble de puces d'un deuxième type (102),
dans lequel ledit au moins un ensemble de puces d'un premier type (101) est monté en surface sur un premier côté du premier circuit imprimé (103),
dans lequel ledit au moins un ensemble de puces d'un deuxième type (102) est monté en surface sur un deuxième côté du premier circuit imprimé (103), et
dans lequel le deuxième côté du premier circuit imprimé (103) est un côté opposé parallèle au premier côté du premier circuit imprimé (103) ;
dans lequel les puces d'un premier type (101) sont des puces de canal multifaisceau, tandis que les puces d'un deuxième type (102) sont des puces de réseau de synthèse multifaisceau ; le nombre de puces de réseau de synthèse multifaisceau étant de 1, et le nombre de puces de canal multifaisceau étant de 4 ;
dans lequel chaque ensemble de puces de canal multifaisceau est respectivement connecté à différentes broches dans la puce de réseau de synthèse multifaisceau via un réseau multicouche construit par différents canaux de faisceau dans le premier circuit imprimé (103) ;
dans lequel les broches de signal dans chaque ensemble de puces de canal multifaisceau sont respectivement connectées à différents canaux de signal radiofréquence dans le premier circuit imprimé, de manière à être connectées à des unités d'antenne correspondantes ;
dans lequel la puce de réseau de synthèse multifaisceau est configurée pour effectuer une synthèse ou une décomposition de réseau de signaux d'entrée et de sortie des puces de canal multifaisceau ;
dans lequel il y a deux couches de puces de réseau de synthèse multifaisceau, dans lequel les puces de réseau de synthèse multifaisceau de la couche inférieure sont respectivement connectées aux puces de canal multifaisceau correspondantes, et les puces de réseau de synthèse multifaisceau de la couche supérieure sont respectivement connectées à un dispositif de contrôle externe et aux puces de réseau de synthèse multifaisceau de la couche inférieure.

2. Module d'intégration de puces multifaisceau (10) selon la revendication 1, dans lequel les broches d'alimentation de chaque ensemble de puces de canal multifaisceau sont respectivement connectées à des canaux d'alimentation correspondants dans le premier côté du premier circuit imprimé (103), et les broches de contrôle de chaque ensemble de puces de canal multifaisceau sont respectivement connectées à des canaux de contrôle correspondants dans le premier côté du premier circuit imprimé (103).

3. Module d'intégration de puces multifaisceau (10) selon la revendication 1, dans lequel une broche d'alimentation de la puce de réseau de synthèse multifaisceau est connectée à un canal d'alimentation correspondant dans le deuxième côté du premier circuit imprimé (103), et une broche de contrôle de la puce de réseau de synthèse multifaisceau est connectée à un canal de contrôle correspondant dans le deuxième côté du premier circuit imprimé (103).

4. Système de réseau d'antennes à commande de phase, dans lequel le système de réseau d'antennes à commande de phase comprend une unité d'antenne (30), un deuxième circuit imprimé (20), et au moins un ensemble de modules d'intégration de puces multifaisceau (10) selon l'une des revendications 1 à 3.

5. Système de réseau d'antennes à commande de phase selon la revendication 4, dans lequel le deuxième circuit imprimé (20) est pourvu d'un réseau d'alimentation d'antenne, les canaux de signal radiofréquence dans le premier circuit imprimé (103) sont respectivement connectés à des points d'accès du réseau d'alimentation d'antenne, et les points de sortie du réseau d'alimentation d'antenne sont respectivement connectés à différentes unités d'antenne (30).

6. Système de réseau d'antennes à commande de phase selon la revendication 5, dans lequel les canaux de signal radiofréquence dans le premier circuit imprimé (103) sont respectivement connectés à des points d'accès du réseau d'alimentation d'antenne via des liaisons brasées (50), les liaisons brasées (50) ayant un diamètre de section transversale supérieur à une épaisseur de la puce de réseau de synthèse multifaisceau.

7. Système de réseau d'antennes à commande de phase selon la revendication 4, dans lequel le système de réseau d'antennes à commande de phase comprend en outre un module de dissipation de chaleur (40), un côté du module de dissipation de chaleur (40) venant en butée contre les puces d'un premier type (101).
